# EUROPEAN PATENT SPECIFICATION

(11) **EP 0 446 073 B1**
(45) Date of publication and mention of the grant of the patent: **24.01.1996**
(21) Application number: 91301968.3
(22) Date of filing: 08.03.1991
(51) Int. Cl.: H03G 3/20

(54) **A method for improving the precision of power regulation in a radio telephone**
Verfahren zur Genauigkeitsverbesserung von Leistungsregelung in einem Funktelefon
Procédé pour améliorer la précision de régulation de puissance dans un radio-téléphone

(30) Priority: 09.03.1990 FI 901209
(43) Date of publication of application: 11.09.1991
(73) Proprietor: NOKIA MOBILE PHONES LTD., SF-24101 Salo (FI)
(72) Inventor: Lonka, Pekka, SF-24240 Salo (FI)
(74) Representative: Singleton, Jeffrey

(56) References cited:
- GB-A- 2 219 897
- US-A- 4 114 108
- US-A- 4 602 218
- US-A- 4 754 231

## Description

The present invention relates to the regulation of the power of the power amplifier in a radio telephone transmitter, especially in connection with manufacture, in the tuning of the power levels to comply with the specification.

It is a requirement to regulate, within a wide range, the transmission power of both digital and analog radio telephones in cellular networks. The dynamics must be several tens of decibels, for example in a GSM system the power regulation range of the radio telephone transmitter is 13 - 43 dBm, and it is desirable to regulate the power at intervals of 2 dB. The significance of dynamics is especially emphasized in digital radio telephones in which the power leading edge and trailing edge must comply with a certain curve form, for example cos form. The wide dynamics range required causes problems, especially when low power levels are used, since in that case the power level voltage values measured by the power measuring detector are close to each other. The lowest power levels obtained from the power measuring detector may be at a distance of a few millivolts from each other, whereas the difference between the highest power levels may be in volts. For this reason, implementing a good resolution in power measurement is extemely difficult.

There is known from US-A- 4602218 a power regulation method in which the power amplifier is controlled by means of a comparator the inputs of which are a fixed reference voltage and a voltage obtained from a power measuring detector, usually a directional coupler, at the power amplifier output, this voltage having been attenuated by a controllable attenuator. When a high output power is desired, the attenuator is switched to high attenuation, whereupon in a state of equilibrium the voltage after the attenuator is the same as the fixed reference voltage, but the output power of the power amplifier is high. When a low power level is desired, the controllable attenuator is respectively switched to low attenuation. This prior-art method has an advantage in its wide dynamics range, but a disadvantage in that the power leading and trailing edges are very difficult to control. In addition, this method is not suitable for program-controlled tuning of the power levels, since a multiplebit attenuator is more difficult to implement that is a D/A converter.

Also known is another power regulation method which differs from that described above in that the desired value can be selected for the reference voltage by using control lines the code signal of which is converted by a D/A converter into the corresponding rectified voltage, which is used as the reference voltage. The voltage obtained from the power measuring detector is applied directly to one of the input terminals of the differential amplifier or the comparator. In the circuitry according to this method the power leading and trailing edges can be controlled, but owing to the narrow dynamics range, sufficient resolution can be achieved only at high power levels. This is due to the fact that the measuring signal from the power measuring detector is applied directly to the comparator, in which case the voltages of low power levels are close to each other. However, the method is suitable for program-controlled tuning and is therefore applicable to modern computeraided manufacture (CAM).

The prior-art methods mentioned above have, in addition to the disadvantages mentioned, the characteristic that the voltage range available is in use for all power levels, in which case the precision deteriorates at the lower end of the power regulation range, at which the voltage differences measured are small. The highest value of the voltage range available is determined by the typical supply voltage of the battery and logic of portable radio telephone, and it is usually 5 V. If the voltage could be high, the prior-art systems would function satisfactorily, since the difference between the voltages would increase, whereupon the precision in power regulation would be sufficient. The present invention eliminates the disadvantages of the prior-art systems and provides a method by which a satisfactory precision of power control is obtained also in portable radio telephones in which the highest value of the supply voltage is limited. US-A-4754231 discloses an automatic power control circuit for a signal power amplifier of a mobile phone in which the output power is controllable at user-selected power levels.

The invention is defined in the appended claims and may provide for the reference voltage to be adjustable within a range ΔV, in conjunction with a controllable attenuator in which case the said voltage range ΔV is entirely, or for a major part, available for each output power level or power level group of the telephone.

According to the invention, the voltage coming from the power measuring detector may be attenuated in a multiple-step controllable attenuator, and the reference voltage may be adjusted by control to the desired level, in which case there will be a voltage range made up of a number of reference voltage levels available at all times for each power level.

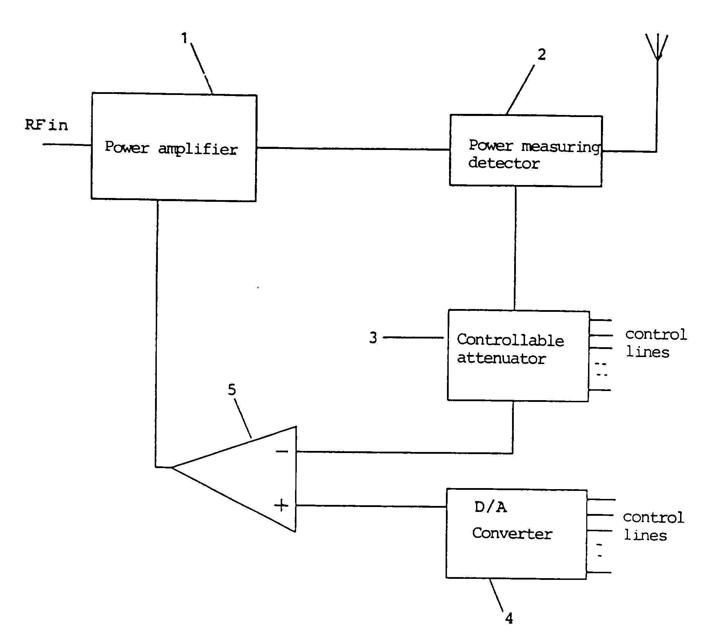

The invention is described in greater detail with reference to the accompanying figure, which depicts the principle of the power amplifier control in a radio telephone when the present invention is used.

In the circuit according to the figure, the comparator 5 regulates the power of the power amplifier 1 in such a manner that the rectified voltage received from the power measuring detector 2, which may be a directional coupler, and coming via the attenuator 3 to the input of the comparator 5, is the same as the reference voltage received from the voltage source 4 and applied to the other input of the comparator 5. The reference voltage is preferably formed by a D/A converter from the code signal of the control lines from the logic, but some other voltage source can also be used from which a selected voltage range ΔV can be obtained. The attenuator 3 has a plurality of attenuation levels which can be controlled via control lines from the logic. When it is desired to have a high amplifier output power level, the attenuator 3 is switched to high attenuation in order not to exceed the voltage range of the D/A converter 4, or other source of reference voltage, which voltage range may be, for example, 0.5 to 4.2 V. In this case this attenuation and the high reference voltage value correspond to a high output power of the telephone. By reducing the value of the reference voltage it is also possible to reduce the output power. At a certain output power level the attenuation is reduced, in which case the reference voltage can be raised to close to its highest value, whereas in the downward direction a number of power levels have available almost the whole voltage range of the reference voltage. When it is desired to have a low power level, the attenuator 3 is switched to very low attenuation, since it is desirable to keep the reference voltage regulation range maximally wide. In this case, by altering the reference voltage value and attenuation it is possible to affect the output power of the telephone.

The voltage range of the reference voltage, comprising 2^{y} voltage levels (y being the number of bits in the control) can be used entirely for a power level group, as described above, or the voltage range can be used for one power level at a time. Thus a wide voltage range has an improving effect on the precision of the power levels. The tuning of the power levels is facilitated and speeded up, and the tuning can be program-controlled. Thereby the manufacturing costs are decreased and the yield of telephones is improved.

The reference voltage can, of course, also be formed in ways other than by a D/A converter, for example directly from the supply voltage by dividing it into a suitable number of voltage levels.

## Claims

1. A method in a digital radio telephone for improving the precision of the regulation of the power of a power amplifier (1) within a power regulation range, including all the power levels, wherein a comparator (5) is used, one input thereof receiving a voltage obtained from a detector (29) measuring the output power of the amplifier (1) and attenuated by a controllable attenuator (3) and the other input thereof receiving a reference voltage controllable within a voltage range (ΔV), the attentuator (3) is controlled between a plurality of attenuation levels each of them providing substantially the voltage range (ΔV), as the attenuated voltage obtained from the detector, for a power level group forming a part of all the power levels, characterized in that
the power of the power amplifier (1) is regulated within any said power level group by adjusting the reference voltage respectively within substantially the voltage range (ΔV).

2. A method according to Claim 1, characterised in that the reference voltage is formed by means of a D/A converter (4) and adjusted by controlling the same.

3. A method according to Claim 1 or 2, characterized in that the attenuator (3) is a multi-step controllable attentuator.

4. The use of the method according to any of the preceding claims, characterised in that the method is used for tuning the power levels to correct level in connection with telephone manufacture.

5. Apparatus in a digital radio telephone for improving the precision of the regulation of the power of a power amplifier (1) within a power regulation range, including all the power levels, wherein a comparator (5) is used, one input thereof receiving a voltage obtained from a detector (29) measuring the output power of the amplifier (1) and attenuated by a controllable attenuator (3) and the other input thereof receiving a reference voltage controllable with in a voltage range (ΔV), the attentuator (3) is controlled between a plurality of attenuation levels each of them providing substantially the voltage range (ΔV), as the attenuated voltage obtained from the detector, for a power level group forming a part of all the power levels and characterised in that
the power of the power amplifier (1) is regulated within any said power level group by adjusting the reference voltage respectively within substantially the voltage range (ΔV).

6. Apparatus according to Claim 1, characterised in that the reference voltage is formed by means of a D/A converter (4) and adjusted by controlling the same.

7. Apparatus according to Claim 1 or 2, characterised in that the attenuator (3) is a multi-step controllable attentuator.

8. The use of the apparatus according to any of Claims 5-7, characterised in that the apparatus is used for tuning the power levels to correct level in connection with telephone manufacture.

## Patentansprüche

1. Verfahren zur Verbesserung der Genauigkeit der Regelung der Leistung eines Leistungsverstärkers (1) innerhalb eines alle Leistungspegel umfassenden Regelungsbereichs in einem digitalen Funktelefon, worin ein Vergleicher (5) benutzt wird, an dessen einen Eingang die von einem die Ausgangsleistung des Verstärkers (1) messenden Detektor (2) erhaltene und von einem steuerbaren Dämpfungsglied (3) gedämpfte Spannung und an dessen anderen Eingang eine in einem Spannungsbereich (ΔV) steuerbare Referenzspannung angelegt werden, wobei das Dämpfungsglied (3) bei mehreren DämpfungspegeIn steuerbar ist, die jeweils im wesentlichen den Spannungsbereich (ΔV), wie die vom Detektor erhaltene gedämpfte Spannung, für eine einen Teil von allen Leistungspegeln bildende Leistungspegelgruppe erzeugen, **dadurch gekennzeichnet**, **daß**
die Regelung der vom Leistungsverstärker (1) abgegebenen Leistung innerhalb irgendeiner dieser Leistungspegelgruppen jeweils durch Einstellen der Referenzspannung im wesentlichen innerhalb des Spannungsbereichs (ΔV) geschieht.

2. Verfahren nach Anspruch 1, **dadurch gekennzeichnet, daß** die Referenzspannung mit Hilfe eines D/A Wandlers (4) erzeugt und durch Steuerung dieses D/A Wandlers (4) eingestellt wird.

3. Verfahren nach Anspruch 1 oder 2, **dadurch gekennzeichnet, daß** das Dämpfungsglied (3) ein steuerbares Mehrstufen-Dämpfungsglied ist.

4. Verwendung des Verfahrens nach einem der vorherigen Ansprüche, **dadurch gekennzeichnet, daß** das Verfahren zur Einstellung der korrekten Leistungspegel im Zusammenhang mit der Telefonherstellung benutzt wird.

5. Vorrichtung zur Verbesserung der Genauigkeit der Regelung der Leistung eines Leistungsverstärkers (1) innerhalb eines alle Leistungspegel umfassenden Regelungsbereichs in einem digitalen Funktelefon, worin ein Vergleicher (5) benutzt wird, an dessen einen Eingang die von einem die Ausgangsleistung des Verstärkers (1) messenden Detektor (2) erhaltene und von einem steuerbaren Dämpfungsglied (3) gedämpfte Spannung und an dessen anderen Eingang eine in einem Spannungsbereich (ΔV) steuerbare Referenzspannung angelegt werden. wobei das Dämpfungsglied (3) bei mehreren Dämpfungspegeln steuerbar ist, die jeweils im wesentlichen den Spannungsbereich (ΔV), wie die vom Detektor erhaltene gedämpfte Spannung, für eine einen Teil von allen LeistungspegeIn bildende Leistungspegelgruppe erzeugen, **dadurch gekennzeichnet, daß**
die Regelung der vom Leistungsverstärker (1) abgegebenen Leistung innerhalb irgendeiner dieser Leistungspegelgruppen jeweils durch Abgleichen der Referenzspannung im wesentlichen innerhalb des Spannungsbereichs (ΔV) geschieht.

6. Vorrichtung nach Anspruch 1, **dadurch gekennzeichnet, daß** die Referenzspannung mit Hilfe eines D/A Wandlers (4) erzeugt und durch Steuerung dieses D/A Wandlers (4) eingestellt wird.

7. Vorrichtung nach Anspruch 1 oder 2, **dadurch gekennzeichnet, daß** daß Dämpfungsglied (3) ein steuerbares Mehrstufen-Dämpfungsglied ist.

8. Verwendung der Vorrichtung nach einem der Ansprüche 5 bis 7, **dadurch gekennzeichnet, daß** die Vorrichtung zur Einstellung der korrekten Leistungspegel im Zusammenhang mit der Telefonherstellung benutzt wird.

## Revendications

1. Procédé, dans un radio téléphone numérique, pour améliorer la précision de la régulation de la puissance d'un amplificateur de puissance (1) à l'intérieur d'une gamme de régulation, incluant tous les niveaux de puissance, dans lequel un comparateur (5) est utilisé, l'une de ses entrées recevant une tension obtenue à partir d'un détecteur (29) mesurant la puissance de sortie de l'amplificateur (1) et atténuée par un atténuateur réglable (3) et l'autre entrée du comparateur recevant une tension de référence réglable à l'intérieur d'une gamme de tensions (ΔV), l'atténuateur (3) étant régulé entre une pluralité de niveaux d'atténuation, chacun d'eux fournissant substantiellement la gamme de tensions (ΔV), comme la tension atténuée obtenue à partir du détecteur, pour un groupe de niveaux de puissance formant une partie de tous les niveaux de puissance, caractérisé en ce que
la puissance de l'amplificateur de puissance (1) est régulée à l'intérieur de chaque dit groupe de niveaux de puissance en ajustant la tension de référence respectivement à l'intérieur de la gamme de tensions (ΔV),substantiellement.

2. Procédé selon la revendication 1, caractérisé en ce que la tension de référence est réalisée au moyen d'un convertisseur (4) et ajustée en réglant ce dernier.

3. Procédé selon la revendication 1 ou 2, caractérisé en ce que l'atténuateur (3) est un atténuateur réglable à plusieurs étages.

4. Utilisation du procédé selon l'une quelconque des revendications précédentes, caractérisé en ce que le procédé est utilisé pour la syntonisation des niveaux de puissance avec les niveaux corrects, en relation avec la fabrication des téléphones.

5. Dispositif, dans un radio téléphone numérique, pour améliorer la précision de la régulation de la puissance d'un amplificateur de puissance (1) à l'intérieur d'une gamme de régulation, incluant tous les niveaux de puissance, dans lequel un comparateur (5) est utilisé, l'une de ses entrées recevant une tension obtenue à partir d'un détecteur (29) mesurant la puissance de sortie de l'amplificateur (1) et atténuée par un atténuateur réglable (3) et l'autre entrée du comparateur recevant une tension de référence réglable à l'intérieur d'une gamme de tensions (ΔV), l'atténuateur (3) étant régulé entre une pluralité de niveaux d'atténuation, chacun d'eux fournissant substantiellement la gamme de tensions (ΔV), comme la tension atténuée obtenue à partir du détecteur, pour un groupe de niveaux de puissance formant une partie de tous les niveaux de puissance, caractérisé en ce que
la puissance de l'amplificateur de puissance (1) est régulée à l'intérieur de chaque dit groupe de niveaux de puissance en ajustant la tension de référence respectivement à l'intérieur de la gamme de tensions (ΔV),substantiellement.

6. Dispositif selon la revendication 1, caractérisé en ce que la tension de référence est réalisée au moyen d'un convertisseur (4) et ajustée en réglant ce dernier.

7. Dispositif selon la revendication 1 ou 2, caractérisé en ce que l'atténuateur (3) est un atténuateur réglable à plusieurs étages.

8. Utilisation du Dispositif selon l'une quelconque des revendications 5 à 7, caractérisé en ce que le procédé est utilisé pour la syntonisation des niveaux de puissance avec les niveaux corrects, en relation avec la fabrication des téléphones.
